# EUROPÄISCHE PATENTSCHRIFT

(11) **EP 0 411 499 B1**
(45) Veröffentlichungstag und Bekanntmachung des Hinweises auf die Patenterteilung: **03.03.1993**
(21) Anmeldenummer: 90114468.3
(22) Anmeldetag: 27.07.1990
(51) Int. Cl.: B05D 1/04, B05B 17/06, B05B 5/08

(54) **Verfahren und Vorrichtung zum Beschichten eines Schichtträgers**
Process and device for coating a substrate
Procédé et dispositif pour le revêtement d'un substrat

(30) Priorität: 02.08.1989 DE 3925539
(43) Veröffentlichungstag der Anmeldung: 06.02.1991
(73) Patentinhaber: HOECHST AKTIENGESELLSCHAFT, 65926 Frankfurt am Main (DE)
(72) Erfinder: Faust, Horst, D-6222 Geisenheim-Johannisberg (DE)

(56) Entgegenhaltungen:
- EP-A- 0 279 371
- WO-A-88/04958
- DE-A- 3 414 245

## Beschreibung

Die Erfindung betrifft ein Verfahren und eine Vorrichtung zum Beschichten eines Schichtträgers mit einer Schicht, die verdampfbare Lösungsmittel- und Feststoffkomponenten enthält, mittels einer elektrischen Entladung, und zum Trocknen der Schicht auf dem Schichtträger.

Es ist bekannt, Leiterplatten im allgemeinen durch Trockenfilm-Laminieren oder durch Naßlackieren von Flüssigresist herzustellen. Die Resist-Lackierverfahren sind Tauchziehen, Walzen, Gießen, Siebdruck und, insbesondere für die Lackierung von Dünnlaminaten, elektrostatische Sprühverfahren.

Das Prinzip des elektrostatischen Sprühverfahrens besteht darin, Flüssigresist an einem Sprühorgan in feinste Tröpfchen zu zerteilen, diese durch Hochspannung elektrisch aufzuladen und auf einem geerdeten Werkstück, beispielsweise einem Substrat, abzuscheiden. Auf der Oberfläche des Substrats verlaufen die Tröpfchen zu einem Naßfilm, der anschließend getrocknet wird.

Aus der europäischen Patentschrift 0 195 041, von welcher die Oberbegriffe der Ansprüche 1 und 13 ansgehen ist ein elektrostatisches Sprühverfahren für die Leiterplatten-Lackierung bekannt, bei dem das Substrat im wesentlichen senkrecht zur Richtung der Sprühvorrichtung in einem elektrostatischen Feld bewegt wird, das durch einen Hochspannungsgenerator erzeugt wird. Der Flüssigresist wird in Richtung des Substrats gesprüht, das durch ein Transportband getragen wird, welches ein elektrostatisches Feld durchquert. Eine Elektrode der elektrostatischen Vorrichtung ist an Masse angeschlossen, während die Sprühvorrichtung für den Flüssigresist mit der Hochspannungselektrode eines Stromgenerators verbunden ist. Die Sprüheinrichtung besteht aus einer Luftturbine, der speziell für Flüssigresist entwickelten Sprühglocke und den Einrichtungen für die Flüssigresistzufuhr. Die Sprühglocke wird beispielsweise mit negativer Gleichspannung im Bereich von 40 bis 90 kV aufgeladen.

Bei der Trocknung großflächiger, bandförmiger Schichtträger, auf denen Flüssigkeitsschichten aufgetragen sind, werden unterschiedliche Trocknungsverfahren und Trocknungsvorrichtungen angewandt. Die aufgetragenen Flüssigkeitsschichten bestehen in der Regel aus verdampfbaren Lösungsmittelkomponenten, die während des Trocknungsprozesses aus dem Flüssigkeitsfilm entfernt werden, und aus nicht-verdampfbaren Feststoffkomponenten, die nach der Trocknung auf dem Trägermaterial zurückbleiben.

Die Beschichtung von Metallbändern mit lichtempfindlichen Schichten, die dann zu Druckplatten konfektioniert werden, bedarf besonderer Anlagen, um die gewünschte Produktqualität der Flüssigresistschichten sicherzustellen.

Aus der DE-A1 37 05 482 sind auch ein Verfahren und eine Anordnung zur Oberflächenvorbehandlung von Kunststoff mittels einer elektrischen Koronaentladung bekannt. Die Anordnung umfaßt einen Generator, der die Entladungselektrode der Koronaentladungseinrichtung mit einem hochfrequenten Wechselstrom hoher Spannung beaufschlagt, wobei als geerdete Gegenelektrode der Metallkern einer Walze dient, über deren Umfangsbeschichtung ein Folienband transportiert wird. Ein Gehäuse umschließt die Entladungselektroden der Koronaentladungseinrichtung und ist über eine Leitung mit einer Zerstäübereinrichtung verbunden, in der eine Flüssigkeit zu einem schwebfähigen Aerosol mittels eines piezoelektrisch arbeitenden Ultraschallschwingsystems oder durch mit Ultraschallgeschwindigkeit arbeitenden Zweistoff-Zerstäuberdüsen zerstäubt wird. Ein in der Durchsatzmenge regulierbares Gebläse ist an die Zerstäubereinrichtung angeschlossen und befördert das Trägergas, beispielsweise Luft, für das Aerosol durch die Zerstäubereinrichtung hindurch in die Koronaentladungseinrichtung.

Aufgabe der Erfindung ist es, ein Verfahren und eine Vorrichtung der eingangs beschriebenen Art so weiterzuentwickeln, daß die Homogenität, die Gleichmäßigkeit und die Verankerung des Schichtaufbaus auf dem Schichtträger bei hoher Beschichtungsgeschwindigkeit und geringem Trocknungsaufwand für den aufgebrachten Schichtaufbau erhöht werden.

Diese Aufgabe wird erfindungsgemäß bei dem Verfahren dadurch gelöst, daß aus einer Beschichtungslösung in einer Zerstäubungszone mittels eines Luft- oder Gasstromes ein Aerosol gebildet wird, daß das Aerosol aus der Zerstäubungszone in eine Verdampfungszone geblasen wird, in der ein großer Anteil des Lösungsmittels verdampft, so daß die Einzeltropfengröße des Aerosols um 50 bis 90 Vol.% gegenüber der Anfangsvolumengröße kleiner wird und daß das Aerosol in einer Antragszone auf den Schichtträger aufgesprüht und die Feststoffkomponenten des Aerosols in einer Trocknungszone auf die Schichtträgeroberfläche aufgeschmolzen werden.

In Ausgestaltung des Verfahrens wird der in der Verdampfungszone entstehende Lösungsmitteldampf abgesaugt, kondensiert und einem Aerosolkreislauf zugeführt.

Ebenso wird der Überschuß an Aerosol der Antragszone zurückgewonnen, indem in Rücklaufzonen zu beiden Seiten der Antragszone der Aerosolüberschuß abgesaugt, das Aerosol in die Lösungsmittel- und Feststoffkomponenten aufgetrennt und die Lösungsmittelkomponenten in den Aerosolkreislauf zurückgeführt werden. Die dabei anfallenden Feststoffkomponenten werden wieder aufgearbeitet.

Die weiterführenden Verfahrensmaßnahmen ergeben sich aus den Merkmalen der Patentansprüche 4 bis 12.

Eine Vorrichtung zum Beschichten eines Schichtträgers mit einer Schicht, die verdampfbare Lösungsmittel- und Feststoffkomponenten enthält, umfaßt eine Hochspannungsquelle zum Erzeugen einer elektrostatischen Entladung in einem Aerosol und einen Trockner für die Schicht auf dem Schichtträger und zeichnet sich dadurch aus, daß ein Ultraschallschwinger mit einem Aerosolkreislauf verbunden ist, in den eine Beschichtungslösung bzw. -dispersion eingeleitet wird, daß der Ultraschallschwinger an einen Zerstäubungsraum angrenzt und in diesen Tropfen der Beschichtungslösung fein verteilt, daß ein Gebläse mit dem Zerstäubungsraum verbunden ist und einen Luft- oder Gasstrom erzeugt, der zusammen mit den Tropfen der Beschichtungslösung das Aerosol bildet, das einer Verdampfungskammer eingespeist wird, in der ein großer Anteil der Lösungsmittelkomponenten des Aerosols verdampft, daß die Verdampfungskammer in eine Breitschlitzdüse mündet, an welcher der Schichtträger vorbeiführt und daß in Laufrichtung des Schichtträgers nach der Breitschlitzdüse der Trockner angeordnet ist, durch den der Schichtträger sich hindurchbewegt.

In Ausgestaltung der Vorrichtung ist eine regelbare Gleichspannungsquelle mit einer Ausgangsspannung von 15 bis 40 kV an den Schichtträger und an den Ultraschallschwinger angeschlossen.

In Weiterbildung der Vorrichtung sind in der Verdampfungskammer außerhalb der Verdampfungszone Wärmestrahlenquellen angeordnet, die durch Wärmestrahlung und Wärmekonvektion das Lösungsmittel des in der Verdampfungszone befindlichen Aerosols verdampfen, und durch Öffnungen in einer Trennwand der Verdampfungskammer wird der Lösungsmitteldampf abgesaugt und durch einen Absaugstutzen über einen Kondensor in den Aerosolkreislauf zurückgeführt. Zweckmäßigerweise ist zu beiden Seiten einer Antragszone der Breitschlitzdüse auf dem Schichtträger je ein Absaugkanal für das überschüssige Aerosol vorhanden, das in einer Trennkammer in die Lösungsmittel- und Feststoffkomponenten aufgetrennt wird, und strömen die Lösungsmittelkomponenten über einen Kondensor in den Aerosolkreislauf zurück.

Die weitere Ausgestaltung der Vorrichtung ergibt sich aus den Merkmalen der patentansprüche 19 bis 24.

Mit der Erfindung werden die Vorteile erzielt, daß die Beschichtungsgeschwindigkeit höher ist als bei herkömmlichen Beschichtungsverfahren von Schichtträgern, bei denen die Flüssigkeitsschicht direkt über eine Breitschlitzdüse auf die Schichtträgeroberfläche aufgetragen wird, daß eine Schichtverblasung im Trockner nicht auftritt, da die Schicht im wesentlichen nur noch aus Feststoffkomponenten besteht und kaum noch Lösungsmittelkomponenten enthält, und daß die Lösungsmittelkomponenten zurückgewonnen werden. Weitere Vorteile ergeben sich durch den relativ geringen Energieaufwand im Trockner zum Verschmelzen des Schichtaufbaus mit dem Schichtträger, durch die Gleichmäßigkeit und Homogenität des Schichtaufbaus, unabhängig von mechanischen Einflußgrößen durch Beschichtungswerkzeuge, wie Breitschlitzdüse, Rakel oder dergleichen, wodurch die erwünschten Eigenschaften der lichtempfindlichen Schicht auf dem Schichtträger verbessert werden, und durch den einfachen technischen Aufbau der Vorrichtung.

Die Erfindung wird im folgenden anhand von zeichnerisch dargestellten Ausführungsbeispielen näher erläutert. Es zeigen:
Figur 1 eine schematische Ansicht einer ersten Ausführungsform der Erfindung mit waagerechter Breitschlitzdüse und senkrecht an der Breitschlitzdüse vorbeibewegtem Schichtträger,
Figur 2 eine vergrößerte Draufsicht auf einen Ausschnitt des Schichtträgers nach Figur 1,
Figur 3 eine zweite Ausführungsform der Vorrichtung nach der Erfindung, die gegenüber der ersten Ausführungsform geringfügig abgewandelt ist,
Figuren 4 und 5 Details einer dritten und vierten Ausführungsform der Vorrichtung, mit gegenüber den Schichtträgern schräg angeordneten Breitschlitzdüsen,
Figur 6 eine fünfte Ausführungsform, bei der die Unterseite des Schichtträgers beschichtet wird, und
Figur 7 eine Seitenansicht im Schnitt des Schichtaufbaus und des Schichtträgers sowie eine Draufsicht auf den Schichtträger mitsamt dem Schichtaufbau.

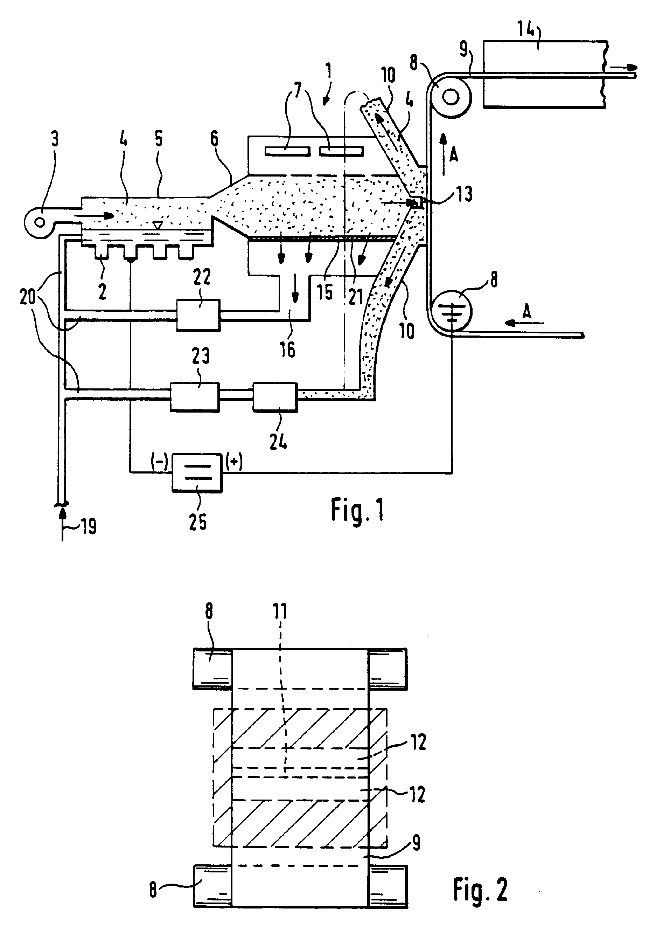

Eine in Figur 1 schematisch gezeigte Vorrichtung 1 zum Beschichten eines Schichtträgers 9 mit einer Flüssigresistschicht umfaßt einen Ultraschallschwinger 2, einen Zerstäubungsraum 5, eine Verdampfungskammer 6 und eine Breitschlitzdüse 13. Der Ultraschallschwinger 2 ist mit einem Aerosolkreislauf 20 verbunden, in welchen eine Beschichtungslösung bzw. -dispersion 19 eingeleitet wird, wie dies durch einen entsprechenden Pfeil in Figur 1 angedeutet ist. Diese Beschichtungslösung 19 wird aus einem nicht dargestellten Behälter zugeführt. Der Ultraschallschwinger 2 grenzt an den Zerstäubungsraum 5 an und bildet mit diesem eine Einheit. Die Beschichtungslösung 19 wird mit einem entsprechenden Verdünnungsgrad dem Ultraschallschwinger 2 zugeführt, der beispielsweise mit einer Frequenz im Bereich von 1 bis 2,5 MHz schwingt. Im Ultraschallschwinger 2 wird die Beschichtungslösung 19 in Tropfen mit einem Durchmesser von etwa 1 bis 3 µm zerstäubt. Ein Gebläse 3 ist mit dem Zerstäubungsraum 5 verbunden und erzeugt einen Luft- oder Gasstrom, der das Trägergas für ein Aerosol 4 bildet. Die Tropfen der Beschichtungslösung 5 bilden zusammen mit dem Trägergas das Aerosol 4, das in Figur 1 im Zerstäubungsraum 5 und in der Verdampfungskammer 6 durch Punkte angedeutet ist. Das Aerosol 4 wird mit einer Geschwindigkeit von etwa 0,4 bis 0,7 m/sec von dem Gebläse 3 aus dem Zerstäubungsraum 5 in die Verdampfungskammer 6 geblasen.

Die Beschichtungslösung 19 besteht aus Lösungsmittel- und Feststoffkomponenten. In der Verdampfungskammer 6 sind oberhalb der Verdampfungszone Wärmestrahlenquellen 7 angeordnet, die durch Wärmestrahlung und Wärmekonvektion das Lösungsmittel des in der Verdampfungszone befindlichen Aerosols verdampfen. Dabei wird ein großer Anteil der Lösungsmittelkomponenten des Aerosols 4 verdampft, so daß die Einzeltropfengröße des Aerosols 4 um 50 bis 90 Volumenprozent gegenüber der Anfangsvolumengröße kleiner wird.

Die Verdampfungskammer 6 geht in die Breitschlitzdüse 13 über, bei der es sich um ein allgemein bekanntes Bauteil handelt und das daher nicht näher beschrieben wird. Die Breitschlitzdüse 13 erstreckt sich über die Gesamtbreite des Schichtträgers 9, bei dem es sich beispielsweise um ein Aluminiumband mit einer Breite bis zu 1200 mm handelt. Selbstverständlich kann dieses Schichtträger-Band auch aus anderen Metallen bestehen, und ebenso kann als Schichtträger ein Kunststoffolien-Band verwendet werden.

In der ersten Ausführungsform der Vorrichtung 1, wie sie in Figur 1 dargestellt ist, sind die Breitschlitzdüse 13, die Verdampfungskammer 6 und der Ultraschallschwinger 2 waagerecht angeordnet. Der Schichtträger 9 wird senkrecht an der Breitschlitzdüse 13 vorbeigeführt. Oberhalb und unterhalb der Breitschlitzdüse 13 befindet sich je eine Umlenkrolle 8 für den Schichtträger 9. In Laufrichtung A des Schichtträgers 9 nach der Breitschlitzdüse 13 ist ein Trockner 14 angeordnet, durch den der Schichtträger 9 hindurchtransportiert wird. Bei dem Trockner 14 handelt es sich um einen herkömmlichen Trockner, der beispielsweise Wärmestrahlenquellen enthält, die im einzelnen nicht gezeigt sind.

Die Verdampfungskammer 6 schließt nach unten mit einer Trennwand 21 ab, in der Öffnungen 15 vorhanden sind, durch die der Lösungsmitteldampf abgesaugt wird, der durch Wärmestrahlung und Wärmekonvektion in der Verdampfungszone innerhalb der Verdampfungskammer 6 entsteht. Der abgesaugte Lösungsmitteldampf gelangt durch einen Absaugstutzen 16 in einen Kondensor 22. Das Sauggebläse für das Absaugen des Lösungsmitteldampfes ist aus Gründen der besseren Übersichtlichkeit nicht eingezeichnet. Im Kondensor 22 wird der Lösungsmitteldampf zu dem flüssigen Lösungsmittel kondensiert und anschließend in den Aerosolkreislauf 20 zurückgeführt.

Zu beiden Seiten der Breitschlitzdüse 13 befindet sich je ein Absaugkanal 10 für das überschüssige Aerosol 4, das auf dem Schichtträger 9 sich nicht niederschlägt. Die beiden Absaugkanäle 10 verlaufen symmetrisch zu der Breitschlitzdüse 13 und sind mit einer Trennkammer 24 verbunden. In Figur 1 ist nur der Anschluß des einen Absaugkanals 10 mit der Trennkammer 24, aus Gründen der besseren Übersichtlichkeit, dargestellt, während der Verlauf des anderen Absaugkanals strichpunktiert ist. In der Trennkammer 24 wird das überschüssige Aerosol in die Lösungsmittel- und Feststoffkomponenten aufgetrennt, und die Lösungsmittelkomponenten werden einem weiteren Kondensor 23 zugeführt, in welchem sie verflüssigt und von dort aus in den Aerosolkreislauf 20 zurückströmen. Das erforderliche Absaugaggregat für das Absaugen des überschüssigen Aerosols durch die Absaugkanäle 10 ist nicht gezeigt. Die in der Trennkammer 24 anfallenden Feststoffkomponenten werden wiederaufgearbeitet.

Eine regelbare Gleichspannungsquelle 25, mit einer Ausgangsspannung von 15 bis 40 kV, ist an den Schichtträger 9 und an den Ultraschallschwinger 2 angeschlossen. Dabei ist der Pluspol der Gleichspannungsquelle 25 mit dem Walzenkern der unteren Umlenkwalze 8 verbunden, über welche der Schichtträger 9 geführt ist, während der Minuspol an dem Ultraschallschwinger 2 angeschlossen ist. Selbstverständlich kann auch die Polung umgekehrt sein, d.h., daß der Schichtträger 9 an den Minuspol und der Ultraschallschwinger 2 an den Pluspol der Gleichspannungsquelle 25 angeschlossen sind.

In Figur 2 ist schematisch ein vergrößerter Ausschnitt des Schichtträgers 9 zwischen den beiden Umlenkwalzen 8 gezeigt. Auf dem Schichtträger 9 ergibt sich eine Antragszone 11, die der Düsenöffnung der Breitschlitzdüse 13 gegenüberliegt. Zu beiden Seiten dieser Antragszone 11 befinden sich Rücklaufzonen 12, die den Querschnittsflächen der Absaugkanäle 10 gegenüberliegen. Das in den Rücklaufzonen 12 anfallende überschüssige Aerosol, das nicht in der Antragszone 11 niedergeschlagen wurde, wird durch die Abzugskanäle 10, wie voranstehend schon erläutert wurde, abgesaugt.

Durch die Gleichspannungsquelle 25 liegt der Schichtträger entweder auf positivem oder negativem Potential und das Aerosol 4 im Zerstäubungsraum 5 bzw. in der Breitschlitzdüse 13 entsprechend auf negativem bzw. positivem Potential.

Die Einzeltropfengröße des Aerosols 4 in der Verdampfungskammer 6 wird dem Festkörperzustand in feinster Pulverform der Feststoffkomponenten der Beschichtungslösung angenähert, so daß die durch die Breitschlitzdüse 13 hindurch auf den Schichtträger 9 aufgebrachte Schicht im wesentlichen nur noch die Feststoffkomponenten und kaum noch Lösungsmittelkomponenten enthält. Die Dicke der aufgebrachten Schicht wird durch die Aerosolmenge und durch die Höhe der angelegten Spannung für die elektrostatische Entladung im Aerosol bestimmt.

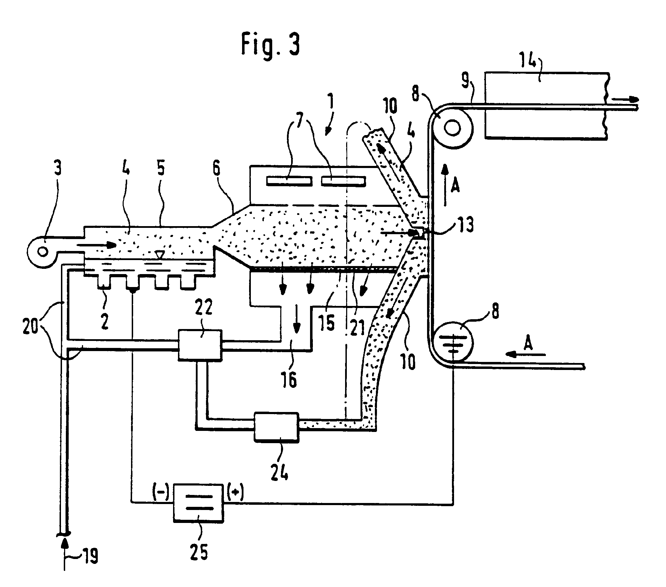

Eine zweite Ausführungsform der Vorrichtung 1 ist in Figur 3 dargestellt. Diese Ausführungsform ist gegenüber der ersten Ausführungsform nach Figur 1 nur geringfügig abgewandelt, so daß nur der Unterschied gegenüber der ersten Ausführungsform beschrieben wird. Ansonsten werden für die gleichen Bauteile die gleichen Bezugszeichen wie bei der ersten Ausführungsform nach Figur 1 verwendet, und deren nochmalige Beschreibung wird unterlassen.

Der Absaugstutzen 16 unterhalb der Trennwand 21 der Verdampfungskammer 6 ist mit einem Kondensor 22 verbunden, an dem auch die Absaugkanäle 10 oberhalb und unterhalb der Breitschlitzdüse 13 angeschlossen sind. Von dem Kondensor 22 führt eine Leitung zu dem Aerosolkreislauf 20. Beide Absaugkanäle 10 führen zunächst zu der Trennkammer 24 und von dieser zu dem gemeinsamen Kondensor 22.

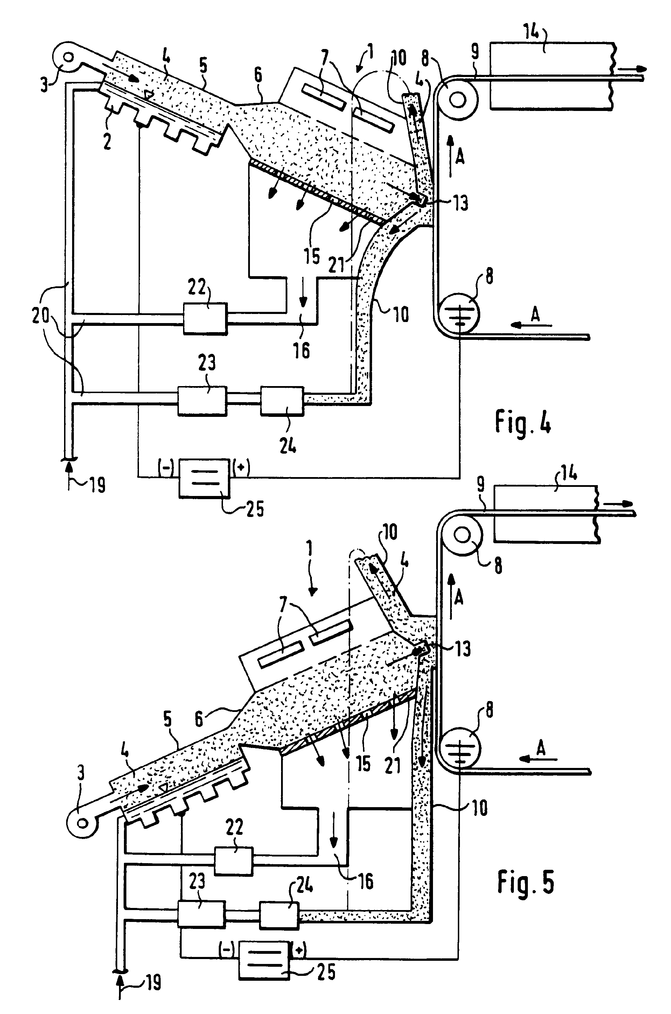

Die dritte und vierte Ausführungsform der Vorrichtung 1 unterscheiden sich gegenüber der ersten Ausführungsform nach Figur 1 nur dadurch, daß die Breitschlitzdüse 13 und die Verdampfungskammer 6 gegenüber dem senkrecht geführten Schichtträger 9 geneigt angeordnet sind, wie dies in den Figuren 4 und 5 schematisch dargestellt ist. In Figur 4 ist die Breitschlitzdüse 13 von oben her gegen die Horizontale geneigt, während nach Figur 5 die Breitschlitzdüse 13 von unten her gegen die Horizontale geneigt ist. Alle übrigen Bauteile der dritten und vierten Ausführungsform sind identisch mit den entsprechend bezeichneten Bauteilen der ersten Ausführungsform nach Figur 1, so daß sich eine Wiederholung der Beschreibung dieser Bauteile und ihre Funktionsweise erübrigt.

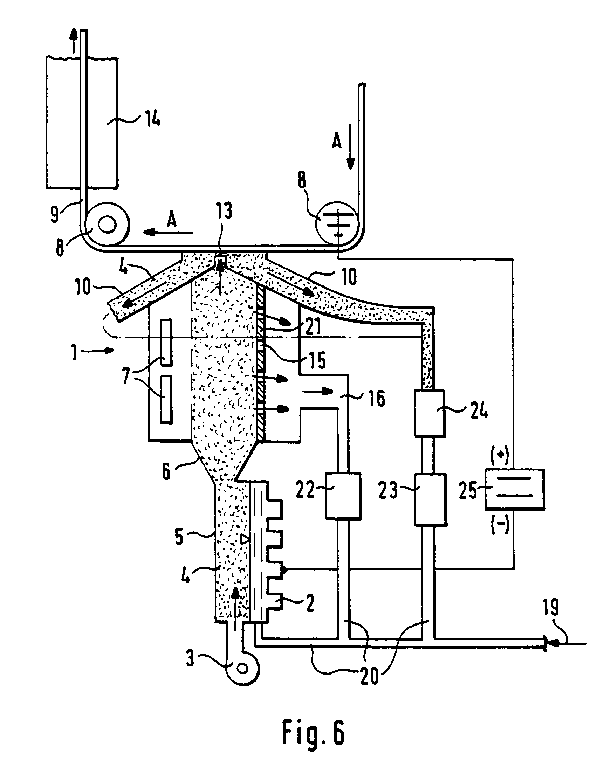

In Figur 6 ist schematisch eine fünfte Ausführungsform der Vorrichtung 1 gezeigt, bei welcher der Schichtträger horizontal an der Breitschlitzdüse 13 vorbeigeführt ist, die zusammen mit der Verdampfungskammer 6, dem Zerstäubungsraum 5, dem Gebläse 3 und dem Ultraschallschwinger 2 unterhalb des Schichtträgers 9 angeordnet ist. Die Breitschlitzdüse 13 ist senkrecht auf die horizontale Unterseite des Schichtträgers 9 gerichtet.

Die übrigen Bauteile der fünften Ausführungsform entsprechen weitgehend den entsprechenden Bauteilen der ersten Ausführungsform, so daß sie nicht nochmals beschrieben werden. Obwohl dies nicht gezeigt ist, kann die Breitschlitzdüse 13 bei weiteren Ausführungsformen auch gegenüber der Unterseite des horizontal geführten Schichtträgers 9 geneigt angeordnet sein. Dementsprechend sind dann die übrigen Baugruppen der Vorrichtung, soweit sie in unmittelbarer Verbindung mit der Breitschlitzdüse 13 stehen, entsprechend geneigt gegenüber dem Schichtträger 9 angeordnet.

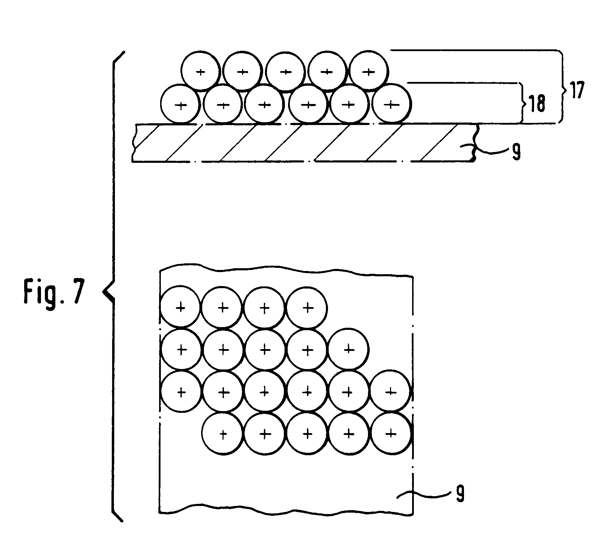

In Figur 7 sind schematisch ein Schnitt durch den Schichtaufbau und den Schichtträger sowie eine Draufsicht auf den Schichtträger mit seinem Schichtaufbau dargestellt.

Wie schon voranstehend erwähnt wurde, ergibt sich in der Verdampfungskammer 6 eine Tropfengröße des Aerosols, die sich dem Festkörperzustand in feinster Pulverform der Feststoffkomponenten nähert. Das Aerosol 4 wird mit der Breitschlitzdüse 13 auf den bandförmigen Schichtträger 9 in der Antragszone 11 aufgesprüht. Durch die entgegengesetzte Aufladung von Aerosol und dem Schichtträger wird ein flächendeckender Schichtaufbau 17 erreicht, wie er in Figur 7 dargestellt ist. Es werden alle freien Stellen in der Antragszone auf dem Schichtträger 9 mit Aerosol in Tropfen- bzw. Kugelform belegt. In Figur 7 ist ein Schichtaufbau 17 aus zumindest zwei Einzelschichten 18 dargestellt, jedoch können auch mehrere Einzelschichten 18 aufeinanderliegen. Die positive Ladung der einzelnen Tropfen des Aerosols in den Einzelschichten 18 ist durch ein Pluszeichen angedeutet. Es ist jedoch ebenso möglich, daß das Aerosol negativ aufgeladen und der Schichtträger auf positives Potential gelegt ist. Die Schichtdicke des Schichtaufbaus 17 wird durch die Anzahl der aufeinanderliegenden Einzelschichten 18 bestimmt. Durch mehrere Beschichtungsvorgänge wird im allgemeinen der Schichtaufbau 17 aus aufeinanderliegenden Einzelschichten 18 gebildet. Dies kann in der Weise geschehen, daß der Schichtträger an mehreren Breitschlitzdüsen 13 nacheinander vorbeigeführt wird oder im geschlossenen Kreislauf mehrmals an einer einzelnen Breitschlitzdüse 13 vorbeiläuft. Ebenso ist es möglich, den Schichtaufbau 17 aus mehreren Einzelschichten 18 in einem einzelnen Beschichtungsvorgang auf dem Schichtträger 9 zu erzeugen, indem für die elektrostatische Entladung eine höhere Spannung als für eine Einzelschicht angelegt und eine größere Aerosolmenge als für eine Einzelschicht durch die Breitschlitzdüse auf den Schichtträger aufgesprüht wird.

Die in Tropfen- bzw. Kugelform flächendeckend auf dem Schichtträger 9 verankerten Einzelschichten des Aerosols, schon in den Festzustand übergehend, werden im nachfolgenden Trockner 14, beispielsweise mit Strahlungswärme, miteinander und mit der Schichtträgeroberfläche verschmolzen.

## Patentansprüche

1. Verfahren zum Beschichten eines Schichtträgers mit einer Schicht, die verdampfbare Lösungsmittel- und Feststoffkomponenten enthält, mittels einer elektrischen Entladung, und zum Trocknen der Schicht auf dem Schichtträger, dadurch gekennzeichnet, daß aus einer Beschichtungslösung in einer Zerstäubungszone mittels eines Luft- oder Gasstromes ein Aerosol gebildet wird, daß das Aerosol aus der Zertäubungszone in eine Verdampfungszone geblasen wird, in der ein großer Anteil des Lösungsmittels verdampft, so daß die Einzeltropfengröße des Aerosols um 50 bis 90 Volumenprozent gegenüber der Anfangsvolumengröße kleiner wird und daß das Aerosol in einer Antragszone auf den Schichtträger aufgesprüht und die Feststoffkomponenten des Aerosols in einer Trocknungszone auf die Schichtträgeroberfläche aufgeschmolzen werden.

2. Verfahren nach Anspruch 1, dadurch gekennzeichnet, daß der in der Verdampfungszone entstehende Lösungsmitteldampf abgesaugt, kondensiert und einem Aerosolkreislauf zugeführt wird.

3. Verfahren nach den Ansprüchen 1 und 2, dadurch gekennzeichnet, daß der Überschuß an Aerosol der Antragszone in Rücklaufzonen zu beiden Seiten der Antragszone abgesaugt, das Aerosol in die Lösungsmittel- und Feststoffkomponenten aufgetrennt und die Lösungsmittelkomponenten in den Aerosolkreislauf zurückgeführt werden und daß die Feststoffkomponenten wieder aufgearbeitet werden.

4. Verfahren nach Anspruch 1, dadurch gekennzeichnet, daß der Schichtträger auf positivem Potential liegt und das Aerosol durch die elektrische Entladung auf negatives Potential gelegt wird.

5. Verfahren nach Anspruch 1, dadurch gekennzeichnet, daß in der Verdampfungszone die Verdampfungsenergie für das Lösungsmittel der Beschichtungslösung durch Wärmestrahlung und -konvektion zugeführt wird.

6. Verfahren nach Anspruch 1, dadurch gekennzeichnet, daß der Schichtträger bandförmig ausgebildet ist und kontinuierlich durch die Antragszone hindurchtransportiert wird.

7. Verfahren nach Anspruch 6, dadurch gekennzeichnet, daß der Schichtträger vertikal durch die Antragszone hindurchgeführt wird und daß das Aerosol auf den Schichtträger horizontal oder schräg aufgesprüht wird.

8. Verfahren nach Anspruch 6, dadurch gekennzeichnet, daß das Aerosol auf die Unterseite des horizontal geführten Schichtträgers aufgesprüht wird.

9. Verfahren nach Anspruch 1, dadurch gekennzeichnet, daß die Einzeltropfengröße des Aerosols in der Verdampfungszone dem Festkörperzustand in feinster Pulverform der Feststoffkomponenten der auf den Schichtträger aufzubringenden Schicht angenähert wird.

10. Verfahren nach Anspruch 1, dadurch gekennzeichnet, daß die Aerosolmenge durch mehrere Beschichtungsvorgänge in aufeinanderliegenden Schichten auf den Schichtträger aufgebracht wird.

11. Verfahren nach Anspruch 1, dadurch gekennzeichnet, daß die Dicke der aufgebrachten Schicht durch die Menge an Aerosol und die Höhe der Spannung der elektrostatischen Entladung bestimmt wird.

12. Verfahren nach den Ansprüchen 10 und 11, dadurch gekennzeichnet, daß das Aerosol in Kugelform flächendeckend auf dem Schichtträger verankert wird und daß die Aerosoltropfen in der Trocknungszone miteinander und mit der Schichtträgeroberfläche durch Wärmestrahleneinwirkung verschmelzen.

13. Vorrichtung zum Beschichten eines Schichträgers mit einer Schicht, die verdampfbare Lösungsmittel- und Feststoffkomponenten enthält, mit einer Hochspannungsquelle zum Erzeugen einer elektrostatischen Entladung in einem Aerosol und einem Trockner für die Schicht auf dem Schichtträger, dadurch gekennzeichnet, daß ein Ultraschallschwinger (2) mit einem Aerosolkreislauf (20) verbunden ist, in den eine Beschichtungslösung bzw. -dispersion (19) eingeleitet wird, daß der Ultraschallschwinger (2) an einen Zerstäubungsraum (5) angrenzt und in diesen Tropfen der Beschichtungslösung fein verteilt, daß ein Gebläse (3) mit dem Zerstäubungsraum verbunden ist und einen Luft- oder Gasstrom erzeugt, der zusammen mit den Tropfen der Beschichtungslösung (19) das Aerosol (4) bildet, das einer Verdampfungskammer (6) eingespeist wird, in der ein großer Anteil der Lösungsmittelkomponenten des Aerosols (4) verdampft, daß die Verdampfungskammer (6) in eine Breitschlitzdüse (13) mündet, an welcher der Schichtträger (9) vorbeiführt, und daß in Laufrichtung (A) des Schichtträgers (9) nach der Breitschlitzdüse (13) der Trockner (14) angeordnet ist, durch den der Schichtträger sich hindurchbewegt.

14. Vorrichtung nach Anspruch 13, dadurch gekennzeichnet, daß eine regelbare Gleichspannungsquelle (25) mit einer Ausgangsspannung von 15 bis 40 kV an den Schichtträger (9) und an den Ultraschallschwinger (2) angeschlossen ist.

15. Vorrichtung nach Anspruch 14, dadurch gekennzeichnet, daß der Schichtträger (9) an den Pluspol angeschlossen und der Ultraschallschwinger (2) mit dem Minuspol der Gleichspannungsquelle (25) verbunden sind.

16. Vorrichtung nach Anspruch 14, dadurch gekennzeichnet, daß der Schichtträger (9) an den Minuspol und der Ultraschallschwinger (2) an den Pluspol der Gleichspannungsquelle (25) angeschlossen sind.

17. Vorrichtung nach Anspruch 13, dadurch gekennzeichnet, daß in der Verdampfungskammer (6) oberhalb der Verdampfungszone Wärmestrahlenquellen (7) angeordnet sind, die durch Wärmestrahlung und Wärmekonvektion das Lösungsmittel des in der Verdampfungszone befindlichen Aerosols verdampfen und daß durch Öffnungen (15) in einer Trennwand (21) der Verdampfungskammer der Lösungsmitteldampf abgesaugt und durch einen Absaugstutzen (16) über einen Kondensor (22) in den Aerosolkreislauf (20) zurückgeführt wird.

18. Vorrichtung nach Anspruch 13, dadurch gekennzeichnet, daß zu beiden Seiten einer Antragszone (11) der Breitschlitzdüse (13) auf dem Schichtträger (9) je ein Absaugkanal (10) für das überschüssige Aerosol vorhanden ist, das in einer Trennkammer (24) in die Lösungsmittel- und Feststoffkomponenten aufgetrennt wird und daß die Lösungsmittelkomponenten über einen Kondensor (23) in den Aerosolkreislauf (20) zurückströmen.

19. Vorrichtung nach den Ansprüchen 13 bis 18, dadurch gekennzeichnet, daß sowohl der Absaugstutzen (16) der Verdampfungskammer (6) als auch die Absaugkanäle (10) neben der Breitschlitzdüse (13) über einen gemeinsamen Kondensor (22) an den Aerosolkreislauf (20) angeschlossen sind.

20. Vorrichtung nach Anspruch 13, dadurch gekennzeichnet, daß die Breitschlitzdüse (13) zusammen mit der Verdampfungskammer (6) sich waagerecht über die Breite des senkrecht an der Breitschlitzdüse vorbeigeführten Schichtträgers (9) erstreckt.

21. Vorrichtung nach Anspruch 13, dadurch gekennzeichnet, daß die Breitschlitzdüse (13) und die Verdampfungskammer (6) gegenüber dem senkrecht geführten Schichtträger (9) geneigt angeordnet sind.

22. Vorrichtung nach Anspruch 13, dadurch gekennzeichnet, daß die Breitschlitzdüse (13) und die Verdampfungskammer (6) unterhalb des waagerecht geführten Schichtträgers (9) sich befinden.

23. Vorrichtung nach Anspruch 13, dadurch gekennzeichnet, daß das aus der Breitschlitzdüse (13) austretende Aerosol als Einzelschicht (18) aus nebeneinanderliegenden Tropfen auf dem Schichtträger (9) sich niederschlägt und daß durch mehrere Beschichtungsvorgänge ein Schichtaufbau (17) aus aufeinanderliegenden Einzelschichten gebildet wird.

24. Vorrichtung nach Anspruch 13, dadurch gekennzeichnet, daß ein Schichtaufbau (17) aus mehreren Einzelschichten (18) in einem einzelnen Beschichtungsvorgang auf dem Schichtträger (9) erzeugt wird, indem für die elektrostatische Entladung eine höhere Spannung als für eine Einzelschicht angelegt und eine größere Aerosolmenge als für eine Einzelschicht aufgesprüht wird.

## Claims

1. A process for coating a substrate with a film which contains vaporizable solvent components and solid components, by means of an electric discharge, and for drying the film on the substrate, wherein an aerosol is formed from a coating solution in an atomizing zone by means of an air stream or gas stream, wherein the aerosol is blown out of the atomizing zone into a vaporizing zone, in which a large proportion of the solvent vaporizes, so that the individual drop size of the aerosol is 50 to 90 percent by volume smaller than the initial volume size and wherein the aerosol is sprayed onto the substrate in an application zone and the solid components of the aerosol are fused onto the substrate surface in a drying zone.

2. The process as claimed in claim 1, wherein the solvent vapor produced in the vaporizing zone is extracted, condensed and fed to an aerosol circuit.

3. The process as claimed in claims 1 and 2, wherein the excess of aerosol of the application zone is extracted in return zones on both sides of the application zone, the aerosol is separated into the solvent components and solid components and the solvent components are returned to the aerosol circuit and wherein the solid components are reprocessed.

4. The process as claimed in claim 1, wherein the substrate is at positive potential and the aerosol is given negative potential by the electric discharge.

5. The process as claimed in claim 1, wherein the vaporization energy for the solvent is fed to the coating solution in the vaporizing zone by heat radiation and heat convection.

6. The process as claimed in claim 1, wherein the substrate is of strip form and is transported continuously through the application zone.

7. The process as claimed in claim 6, wherein the substrate is taken vertically through the application zone and wherein the aerosol is sprayed horizontally or obliquely onto the substrate.

8. The process as claimed in claim 6, wherein the aerosol is sprayed onto the underside of the horizontally taken substrate.

9. The process as claimed in claim 1, wherein the individual drop size of the aerosol in the vaporizing zone approximates the state of the solids in superfine powder form of the solid components of the film to be applied to the substrate.

10. The process as claimed in claim 1, wherein the quantity of aerosol is applied to the substrate in films lying one on top of the other by a plurality of coating operations.

11. The process as claimed in claim 1, wherein the thickness of the film applied is determined by the quantity of aerosol and the amplitude of the voltage of the electrostatic discharge.

12. The process as claimed in claims 10 and 11, wherein the aerosol is anchored on the substrate in bead form over the entire surface and wherein the aerosol drops in the drying zone fuse with one another and with the substrate surface by the action of heat radiation.

13. An apparatus for coating a substrate with a film which contains vaporizable solvent components and solid components, comprising a high-voltage source for generating an electrostatic discharge in an aerosol and a dryer for drying the film on the substrate, wherein an ultrasonic generator (2) is connected to an aerosol circuit (20) into which a coating solution or coating dispersion (19) is introduced, wherein the ultrasonic generator (2) is adjacent an atomizing space (5) and finely distributes drops of the coating solution into the latter, wherein a fan (3) is connected to the atomizing space and generates an air stream or gas stream, which together with the drops of the coating solution (19) forms the aerosol (4), which is fed to a vaporization chamber (6), in which a large proportion of the solvent components of the aerosol (4) vaporizes, wherein the vaporization chamber (6) opens into a fishtail nozzle (13), past which the substrate (9) runs, and wherein the dryer (14) through which the substrate passes is arranged downstream of the fishtail nozzle (13) in the running direction (A) of the substrate (9).

14. The apparatus as claimed in claim 13, wherein a controllable DC voltage source (25) having an output voltage of 15 to 40 kV is corrected to the substrate (9) and to the ultrasonic generator (2).

15. The apparatus as claimed in claim 14, wherein the substrate (9) is connected to the positive pole and the ultrasonic generator (2) is connected to the negative pole of the DC voltage source (25).

16. The apparatus as claimed in claim 14, wherein the substrate (9) is connected to the negative pole and the ultrasonic generator (2) is connected to the positive pole of the DC voltage source (25).

17. The apparatus as claimed in claim 13, wherein heat radiation sources (7) are arranged in the vaporization chamber (6) above the vaporizing zone, which sources vaporize the solvent of the aerosol located in the vaporizing zone by heat radiation and heat convection and wherein the solvent vapor is extracted through openings (15) in a dividing wall (21) of the vaporization chamber and returned to the aerosol circuit (20) through an extraction branch (16) via a condenser (22).

18. The apparatus as claimed in claim 13, wherein there is on either side of an application zone (11) of the fishtail nozzle (13) on the substrate (9) an extraction channel (10) for the excess aerosol, which is separated in a separating chamber (24) into the solvent components and solid components, and wherein that the solvent components flow back into the aerosol circuit (20) via a condenser (23).

19. The apparatus as claimed in claims 13 to 18, wherein both the extraction branch (16) of the vaporization chamber (6) and the extraction channels (10) next to the fishtail nozzle (13) are connected to the aerosol circuit (20) via a common condenser (22).

20. The apparatus as claimed in claim 13, wherein the fishtail nozzle (13) extends together with the vaporization chamber (6) horizontally over the width of the substrate (6) taken perpendicularly past the fishtail nozzle.

21. The apparatus as claimed in claim 13 wherein the fishtail nozzle (13) and the vaporization chamber (6) are arranged at an inclination to the vertically taken substrate (9).

22. The apparatus as claimed in claim 13, wherein the fishtail nozzle (13) and the vaporization chamber (6) are located underneath the horizontally taken substrate (9).

23. The apparatus as claimed in claim 13, wherein the aerosol emerging from the fishtail nozzle (13) precipitates as an individual film (18) of drops lying next to one another on the substrate (9) and wherein a film structure (17) of individual films lying one on top of the other is formed by a plurality of coating operations.

24. The apparatus as claimed in claim 13, wherein a film structure (17) of a plurality of individal films (18) is produced on the substrate (9) in a single coating operation by applying a higher voltage for the electrostatic discharge than for a single film and spraying on a greater quantity of aerosol than for a single film.

## Revendications

1. Procédé pour le revêtement d'un substrat avec une couche contenant des composants solvants évaporables et des composants solides, à l'aide d'une décharge électrique, et pour le séchage de la couche sur le substrat, caractérisé en ce qu'on forme un aérosol à partir d'une solution d'enduction, dans une zone d'atomisation, au moyen d'un courant d'air ou de gaz, on souffle l'aérosol de la zone d'atomisation dans une zone d'évaporation dans laquelle une grande partie du solvant se vaporise de telle sorte que la taille des gouttes individuelles d'aérosol soit inférieure de 50 à 90 % en volume à leur volume initial, on pulvérise l'aérosol sur le substrat dans une zone d'enduction et on fond les composants solides de l'aérosol à la surface du substrat, dans une zone de séchage.

2. Procédé selon la revendication 1, caractérisé en ce qu'on aspire la vapeur de solvant produite dans la zone d'évaporation, on la condense et on l'envoie dans un circuit d'aérosol.

3. Procédé selon les revendications 1 et 2, caractérisé en ce qu'on aspire l'excès d'aérosol depuis la zone d'enduction vers des zones de recyclage situées des deux côtés de la zone d'enduction, on sépare l'aérosol en ses composants solvants et solides, on renvoie les composants solvants dans le circuit aérosol et on retraite les composants solides.

4. Procédé selon la revendication 1, caractérisé en ce que le substrat est à un potentiel positif et que l'aérosol est mis à un potentiel négatif par la décharge électrique.

5. Procédé selon la revendication 1, caractérisé en ce que l'apport d'énergie d'évaporation du solvant de la solution d'enduction, dans la zone d'évaporation, est fourni par rayonnement thermique et convection thermique.

6. Procédé selon la revendication 1, caractérisé en ce que le substrat est sous forme d'une bande et est acheminé en continu dans la zone d'enduction.

7. Procédé selon la revendication 6, caractérisé en ce que le substrat est acheminé verticalement dans la zone d'enduction et que l'aérosol est pulvérisé horizontalement ou obliquement sur le substrat.

8. Procédé selon la revendication 6, caractérisé en ce que l'aérosol est pulvérisé sur la face inférieure du substrat défilant horizontalement.

9. Procédé selon la revendication 1, caractérisé en ce que la taille des gouttes individuelles d'aérosol dans la zone d'évaporation est approximativement celle de l'état des solides sous forme de poudre très fine des composants solides de la couche à déposer sur le substrat.

10. Procédé selon la revendication 1, caractérisé en ce que la quantité d'aérosol est déposée sur le substrat en couches superposées, au cours de plusieurs étapes d'enduction.

11. Procédé selon la revendication 1, caractérisé en ce que l'épaisseur de la couche déposée est déterminée par la quantité d'aérosol et par l'amplitude de la tension de la décharge électrostatique.

12. Procédé selon les revendications 10 et 11, caractérisé en ce que l'aérosol est ancré sur toute la surface du substrat sous forme de perles et que les gouttes d'aérosol dans la zone de séchage sont réunies par fusion entre elles et avec la surface du substrat sous l'effet d'un rayonnement thermique.

13. Dispositif pour le revêtement d'un substrat avec une couche contenant des composants solvants évaporables et des composants solides, qui comprend une source haute tension, pour produire une charge électrostatique dans un aérosol, et un séchoir pour la couche sur le substrat, et qui est caractérisé par le fait qu'un générateur d'ultrasons (1) est relié à un circuit d'aérosol (20) dans lequel passe une solution ou une dispersion d'enduction (19), que le générateur d'ultrasons (2) est contigu à une zone d'atomisation (5) et fragmente finement dans cette dernière des gouttes de la solution d'enduction, qu'un ventilateur (3) est relié à la zone d'atomisation et produit un courant d'air ou de gaz qui forme l'aérosol (4) avec les gouttes de solution d'enduction (19), lequel aérosol est envoyé dans une chambre de vaporisation (6) dans laquelle est évaporée une grande partie des composants solvants de l'aérosol (4), que la chambre d'évaporation (6) débouche dans une filière à fente large (13) devant laquelle défile le substrat (9), et que le séchoir (14), à travers lequel passe le substrat, est disposé en aval de la filière à fente large (13), dans le sens du mouvement (A) du substrat (9).

14. Dispositif selon la revendication 13, caractérisé en ce qu'une source de courant continu réglable (25), dont la tension initiale vaut de 15 à 40 kV, est reliée au substrat (9) et au générateur d'ultrasons (2).

15. Dispositif selon la revendication 14, caractérisé en ce que le substrat (9) est connecté au pôle positif et que le générateur d'ultrasons (2) est connecté au pôle négatif de la source de courant continu (25).

16. Dispositif selon la revendication 14, caractérisé en ce que le substrat (9) est connecté au pôle négatif et que le générateur d'ultrasons (2) est connecté au pôle positif de la source de courant continu (25).

17. Dispositif selon la revendication 13, caractérisé en ce que, dans la chambre d'évaporation (6), sont disposées, au-dessus de la zone d'évaporation, des sources de rayonnement thermique (7) qui vaporisent, par rayonnement thermique et convection thermique, le solvant de l'aérosol se trouvant dans la zone d'évaporation, et que la vapeur de solvant est aspirée par des orifices (15) pratiqués dans une paroi séparatrice (21) de la chambre d'évaporation et recyclée, par l'intermédiaire d'un raccord d'aspiration (16) via un condenseur (22), dans le circuit d'aérosol (20).

18. Dispositif selon la revendication 13, caractérisé en ce que, sur chacun des deux côtés d'une zone d'enduction (11) de la filière à fente large (13) sur le substrat (9), est présent un canal d'aspiration (10) pour l'aérosol en excès qui est séparé, dans une chambre de séparation (24), en composants solvants et composants solides, et que les composants solvants sont recyclés dans le circuit d'aérosol (20) par un condenseur (23).

19. Dispositif selon les revendications 13 à 18, caractérisé en ce qu'aussi bien le record d'aspiration (16) de la chambre d'évaporation (6) que les canaux d'aspiration (10) proches de la filière à fente large (13) sont reliés par un condenseur commun (22) au circuit d'aérosol (20).

20. Dispositif selon la revendication 13, caractérisé en ce que la filière à fente large (13) ainsi que la chambre d'évaporation (6) s'étendent horizontalement sur toute la largeur du substrat (9) qui se déplace verticalement devant la filière à fente large.

21. Dispositif selon la revendication 13, caractérisé en ce que la filière à fente large (13) et la chambre d'évaporation (6) sont en position inclinée par rapport au substrat (9) qui se déplace verticalement.

22. Dispositif selon la revendication 13, caractérisé en ce que la filière à fente large (13) et la chambre d'évaporation (6) se trouvent au-dessous du substrat (9) qui se déplace horizontalement.

23. Dispositif selon la revendication 13, caractérisé en ce que l'aérosol sortant de la filière à fente large (13) précipite en une couche unique (18) de gouttes conjointes sur le substrat (9) et qu'il se forme, par plusieurs opérations d'enduction, une structure de couche 17 formée de couches individuelles superposées.

24. Dispositif selon la revendication 13, caractérisé en ce qu'on produit sur le substrat (9), en une seule opération d'enduction, une structure de couche (17) à partir de plusieurs couches individuelles (18), en appliquant, pour la décharge électrostatique, une tension plus élevée que pour une couche unique et en pulvérisant une plus grande quantité d'aérosol que pour une couche unique.
